# FASCICULE DE BREVET EUROPEEN

(11) **EP 4 639 185 B1**
(45) Date de publication et mention de la délivrance du brevet: **04.11.2026**
(21) Numéro de dépôt: 23836463.2
(22) Date de dépôt: 20.12.2023
(51) Int. Cl.: G01R 15/18

(54) **COMPOSANT ÉLECTRIQUE ET PROCÉDÉ DE FABRICATION D'UN TEL COMPOSANT ÉLECTRIQUE**
ELEKTRISCHES BAUELEMENT UND VERFAHREN ZUR HERSTELLUNG EINES SOLCHEN ELEKTRISCHEN BAUELEMENTS
ELECTRICAL COMPONENT AND METHOD FOR MANUFACTURING SUCH AN ELECTRICAL COMPONENT

(30) Priorité: 21.12.2022 FR 2214109
(43) Date de publication de la demande: 29.10.2025
(73) Titulaire: SCHNEIDER ELECTRIC INDUSTRIES SAS, 92500 Rueil-Malmaison (FR)
(72) Inventeur: CHANVILLARD, Christophe, 38320 EYBENS (FR); RONDOT, Loïc, 38240 MEYLAN (FR); WOLOZAN, Stéphane, 38130 ECHIROLLES (FR)
(74) Mandataire: Lavoix
(86) Numéro de dépôt international: PCT/EP2023/086819
(87) Numéro de publication internationale: WO 2024/133378

(56) Documents cités:
- CN-A- 109 164 287
- FR-A1- 3 109 637

## Description

La présente invention concerne un composant électrique et un procédé de fabrication d'un tel composant électrique.

Un capteur de courant électrique est utilisé pour mesurer l'intensité d'un courant électrique circulant dans une ligne électrique. Une telle mesure peut s'avérer nécessaire pour quantifier la puissance et/ou l'énergie électrique consommée par un récepteur électrique ou pour détecter une anomalie de fonctionnement du récepteur. En tant que capteur, il est connu d'utiliser un capteur de courant de type Rogowski, qui met en oeuvre un ou plusieurs enroulements de fil conducteur autour d'un noyau amagnétique, ce type de capteur étant généralement associé à un circuit de traitement du signal incluant un circuit intégrateur.

Le capteur peut se présenter par exemple sous la forme d'un enroulement de conducteur qui s'étend le long d'une trajectoire circulaire ou rectangulaire. On obtient donc par exemple un enroulement torique, qui forme une boucle. Durant l'utilisation, la ligne électrique, dont l'intensité doit être mesurée, est positionnée de sorte à traverser la boucle décrite par l'enroulement, au centre de la trajectoire. La ligne électrique est donc radialement entourée par l'enroulement. Pour réduire les perturbations pour la mesure, on peut prévoir que l'enroulement comprend des spires aller qui sont entrecroisées avec des spires retour, ou que les spires retour sont bobinées à l'intérieur ou parallèlement sous des spires aller, ou encore que qu'une partie non bobinée du conducteur, émanant d'une extrémité de l'enroulement de spires aller repasse par l'intérieur de l'enroulement en sens inverse, le long de la trajectoire dudit enroulement. EP3171182A1 donne quelques exemples à ce sujet.

Pour construire ce type d'enroulement, on bobine traditionnellement un fil de cuivre autour d'un noyau en matière plastique polymère de forme torique pour former les spires aller, en prévoyant un conducteur de retour, non bobiné, situé à l'intérieur du noyau, ou en surface du noyau, entre les spires aller. Or, la précision de la mesure d'un capteur de courant de type Rogowski dépend notamment de la précision de la géométrie des spires et de la régularité de leur agencement spatial, et le gain d'un tel capteur augmente avec le nombre de spire que présente l'enroulement et leur taille. Pour obtenir une densité de spires importante et maîtriser avec précision le positionnement des spires, il est donc nécessaire de prévoir des machines de bobinage de fil conducteur complexes et coûteuses. En outre, le conducteur enroulé est susceptible de se déformer durant l'utilisation, par exemple sous l'effet de contraintes thermiques, diminuant les performances du capteur.

Pour répondre à ces inconvénients, il est également connu de construire ce type d'enroulement sur une carte de circuit imprimé multicouches, les spires étant formées par des pistes conductrices en surface et dans l'épaisseur de la carte de circuit imprimé, comme décrit dans FR 3 075 387 A1. Une telle approche donne globalement satisfaction, et permet d'obtenir un capteur de courant plus robuste et dont la fabrication est facilement industrialisable, mais les performances du capteur de courant sont limitées par la densité des spires, elle-même contrainte par les méthodes de fabrication de la carte de circuit imprimé, qui empêchent de former des spires d'épaisseur importante.

Une autre approche connue, par exemple de FR 3 109 637 A1, est de fabriquer un capteur de courant en plastronique, avec une armature formée par une matière plastique polymère et un additif organométallique, comprenant deux branches rectilignes parallèles entre elles, à la surface desquelles sont formées des enroulements à l'aide de pistes conductrices. Deux barreaux réalisés en matériau ferromagnétique s'étendent entre les branches, de manière à obtenir un circuit magnétique en forme de boucle. Une telle approche permet d'obtenir un capteur performant, avec une grande densité de spires, mais nécessite de recourir à des procédés de fabrication coûteux. En effet, le matériau ferromagnétique utilisé pour la fabrication des barreaux est particulièrement coûteux. De plus, ce matériau se comporte comme un amplificateur qui amplifie les défauts liés notamment au positionnement des barreaux, et il est donc nécessaire de maîtriser précisément le positionnement des barreaux pour éviter une dégradation des performances du capteur.

FR 3 109 637 A1 décrit également une autre approche, consistant à proposer un capteur de courant dont l'armature est de forme annulaire, des spires étant formées sur toute la circonférence de l'armature, le capteur de courant étant alors dépourvu de barreaux. Les spires retour sont formées sur une carte de circuit imprimé sur laquelle l'armature est positionnée. Cependant, FR 3 109 637 A1 ne fournit aucune indication sur les moyens de fabriquer un tel capteur de courant. En outre, la forme annulaire rend la fabrication du capteur de courant et son intégration dans un circuit électronique complexe, ne permet pas de positionner facilement des connexions entre les spires formées sur l'armature et la carte de circuit imprimé, et le positionnement de ces connexions entraîne une perte de symétrie du capteur de courant. En particulier, cette perte de symétrie entraîne une sensibilité à la position du conducteur, car lorsque le conducteur n'est pas parfaitement centré par rapport à l'armature de forme annulaire, le gain n'est pas homogène au centre du capteur de courant, et entraîne également une baisse de l'immunité du capteur, qui est davantage susceptible de mesurer un champ magnétique provenant d'un conducteur situé à l'extérieur du capteur.

L'invention vise donc à résoudre les inconvénients susmentionnés de l'art antérieur en proposant un nouveau composant électrique comprenant un enroulement avec une densité de spires élevée et un agencement précis, simple à fabriquer et à intégrer dans un circuit électrique, tout en étant immunisé aux champs magnétiques extérieurs.

À cet effet, l'invention concerne un composant électrique comprenant :
- une armature, qui est formée par un matériau comprenant une matière plastique polymère et un additif organométallique, l'armature délimitant une ouverture centrale, laquelle traverse l'armature selon un axe principal,
- une carte de circuit imprimé, sur laquelle l'armature est fixée, la carte de circuit imprimé et l'armature étant superposées selon l'axe principal, et
- une ligne électrique non-ramifiée, qui comprend un premier point de connexion, un deuxième point de connexion et des segments qui se succèdent depuis le premier point de connexion jusqu'au deuxième point de connexion, selon un sens de circulation de la ligne électrique, chaque segment étant porté soit par l'armature, soit par la carte de circuit imprimé, chaque segment étant connecté au segment suivant par une jonction respective appartenant à la ligne électrique.

Selon l'invention, l'armature comprend au moins quatre bras, les au moins quatre bras étant répartis en boucle autour de l'ouverture centrale, chaque bras de l'armature formant une face extérieure respective appartenant à l'armature et s'étendant parallèlement à l'axe principal et chaque bras portant un seul des segments de la ligne électrique, et au moins quatre jointures, chaque bras étant relié au bras adjacent par l'intermédiaire de l'une des jointures.

De plus, la carte de circuit imprimé comprend au moins quatre branches, les au moins quatre branches étant réparties en boucle autour de l'axe principal et délimitant un trou central, traversé par l'axe principal, chaque branche de la carte de circuit imprimé portant un seul des segments de la ligne électrique

En outre, le premier point de connexion de la ligne électrique est connecté au premier segment de la ligne électrique, selon le sens de circulation, le premier segment étant porté par l'une des branches de la carte de circuit imprimé, et le dernier segment de la ligne électrique, selon le sens de circulation, est connecté au deuxième point de connexion, le dernier segment étant porté par un bras de l'armature.

Enfin, le composant électrique comprend des plots de contact portés par l'armature et disposés chacun à l'une des jointures de l'armature, et chaque jonction entre deux segments consécutifs de la ligne électrique, dont l'un des deux segments consécutifs est porté par un bras de l'armature et dont l'autre des deux segments consécutifs est porté par une branche de la carte de circuit imprimé, est formée par l'un des plots de contact.

Grâce à l'invention, la ligne électrique est entremêlée entre les bras de l'armature et les branches de la carte de circuit imprimé, ce qui confère au composant électrique de bonnes performances, et notamment une bonne immunité aux champs magnétiques. De plus, cet entremêlement est simple à fabriquer, grâce aux plots de contact qui assurent la continuité de la ligne électrique entre l'armature et la carte de circuit imprimé. En outre, l'armature est un composant plastronique, ce qui permet aux segments de la ligne électrique formés sur l'armature de bénéficier d'une densité de spires élevée et d'un placement précis, améliorant ainsi les performances du composant électrique.

Selon des aspects avantageux, mais non obligatoires de l'invention, ce composant électrique incorpore une ou plusieurs des caractéristiques suivantes, prises isolément ou selon toutes combinaisons techniquement admissibles :
- Les plots de contact sont groupés par paires, une jointure de l'armature portant soit une paire de plots de contact, soit aucun plot de contact.
- Le composant électrique comprend quatre paires de plots de contact, et les segments de la ligne électrique, selon le sens de circulation, alternent entre un segment porté par une branche de la carte de circuit imprimé et un segment porté par un bras de l'armature.
- Le composant électrique comprend au moins deux paires de plots de contact, et les segments de la ligne électrique, selon le sens de circulation, alternent entre deux segments consécutifs portés chacun par une branche de la carte de circuit imprimé et deux segments consécutifs portés chacun par un bras de l'armature.
- Le composant électrique comprend au moins une paire de plots de contact, et les segments de la ligne électrique, selon le sens de circulation, alternent entre quatre segments consécutifs portés chacun par une branche de la carte de circuit imprimé et quatre segments consécutifs portés chacun par un bras de l'armature.
- Le composant électrique comprend une ligne électrique auxiliaire, portée par la carte de circuit imprimé, et la ligne électrique auxiliaire est connectée à la ligne électrique entre le quatrième segment et le cinquième segment de la ligne électrique.
- L'armature est fixée sur la carte de circuit imprimé par l'intermédiaire des plots de contact.
- Chaque segment de la ligne électrique porté par un bras de l'armature décrit des spires s'enroulant autour dudit bras de l'armature.
- Une distance minimale séparant deux spires adjacentes d'un segment de la ligne électrique porté par un bras de l'armature, mesurée sur la face plane extérieure dudit bras **de l'armature** perpendiculairement à l'axe principal, est inférieure à 400 µm, de préférence inférieure à 250 µm.
- On définit une première portion de l'armature et une deuxième portion de l'armature, chaque portion de l'armature étant délimitée entre un premier plan radial passant par l'axe principal et un deuxième plan radial passant par l'axe principal et décalé du premier plan radial, un angle de décalage entre le premier plan radial et le deuxième plan radial étant identique pour la première portion de l'armature et pour la deuxième portion de l'armature. Une surface cumulée des spires comprises dans la première portion de l'armature diffère d'une surface cumulée des spires comprises dans la deuxième portion de l'armature de moins de 5%.
- L'ouverture centrale de l'armature est en forme de cylindre droit.
- Le composant électrique est un capteur de type Rogowski.

Selon un autre aspect, l'invention concerne également un procédé de fabrication d'un composant électrique tel que mentionné ci-dessus, ce procédé de fabrication comprenant :
- une préparation de l'armature, comprenant successivement :
   ∘ une fourniture ou une fabrication de l'armature ;
   ∘ une gravure par laser de l'armature, pour graver au moins une piste d'amorce décrivant les segments de la ligne électrique portés par l'armature et décrivant les plots de contact, et où l'additif organométallique est localement activé ;
   ∘ une métallisation de chaque piste d'amorce avec un métal conducteur pour former les segments de la ligne électrique portés par l'armature et pour former les plots de contact directement en surface de l'armature ;
- une fourniture ou une fabrication de la carte de circuit imprimé ;
- un positionnement de l'armature sur la carte de circuit imprimé ; et
- une soudure des plots de contact sur la carte de circuit imprimé.

Avantageusement, la soudure des plots de contact sur la carte de circuit imprimé s'effectue en utilisant un four de refusion par convection dans lequel le composant électrique est placé.

Ce procédé de fabrication induit les mêmes avantages que ceux mentionnés ci-dessus au sujet du composant électrique de l'invention.

L'invention sera mieux comprise et d'autres avantages de celle-ci apparaitront plus clairement à la lumière de la description qui va suivre d'un mode de réalisation d'un composant électrique et d'un procédé de fabrication d'un tel composant électrique donnée uniquement à titre d'exemple et faite en référence aux dessins annexés dans lesquels :
[Fig. 1] La figure 1 est une vue en perspective éclatée d'un composant électrique conforme à un premier mode de réalisation de l'invention.
[Fig. 2] La figure 2 est une vue de dessous d'une partie du composant électrique de la figure 1.
[Fig. 3] La figure 3 est un schéma fonctionnel représentatif du composant électrique de la figure 1.
[Fig. 4] La figure 4 est un schéma fonctionnel représentatif d'un composant électrique conforme à un deuxième mode de réalisation de l'invention.
[Fig. 5] La figure 5 est un schéma fonctionnel représentatif d'un composant électrique conforme à un troisième mode de réalisation de l'invention.

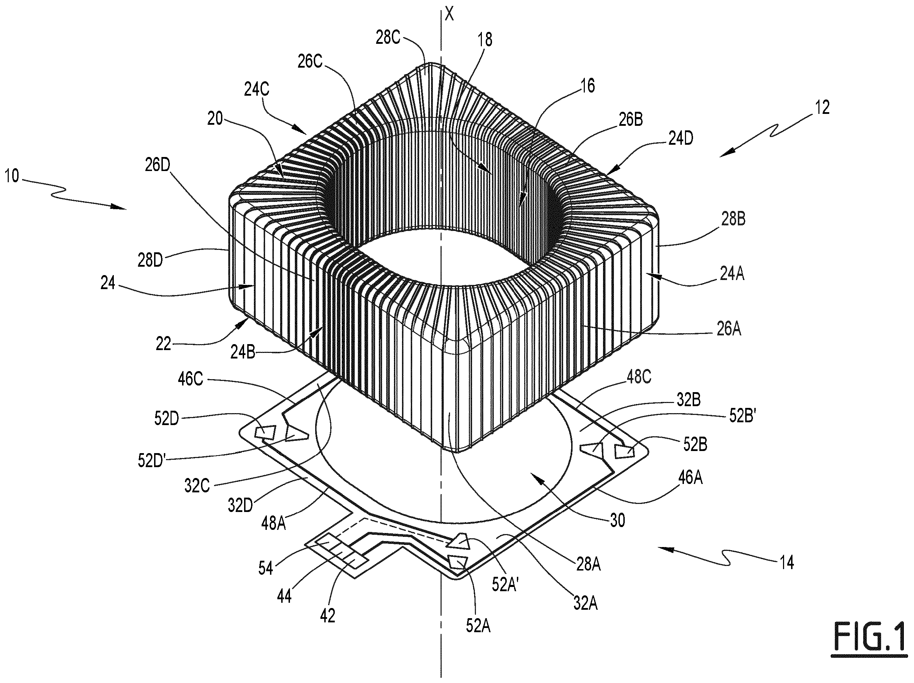

Un composant électrique 10 selon un premier mode de réalisation de l'invention est représenté aux figures 1 à 3. Le composant électrique 10 comprend une armature 12 et une carte de circuit imprimé 14 sur laquelle l'armature 12 est montée.

On utilise un axe de référence X, qui est un axe principal du composant électrique 10. La carte de circuit imprimé 14 est plane et s'étend dans un plan perpendiculaire à l'axe principal X.

L'armature 12 est, de préférence, constituée d'une unique pièce formée d'un seul tenant, c'est-à-dire de façon monolithique, entièrement dans un même matériau.

Le matériau constitutif de l'armature 12 comprend une matière plastique polymère, qui est de préférence une résine thermoplastique, par exemple en polycarbonate (PC), relativement facile à mouler par injection, ou en polymère à cristaux liquides (LCP), résistant particulièrement bien à la chaleur. Le matériau comprend aussi un additif organométallique, intégré à la matière plastique polymère, qui est réparti au moins en peau de l'armature, voire également à cœur. L'additif organométallique, dans un état non-activé, est électriquement non-conducteur. L'armature 12 est donc électriquement non-conductrice et amagnétique, sauf éventuellement pour toute partie activée de l'additif organométallique, comme discuté ci-après.

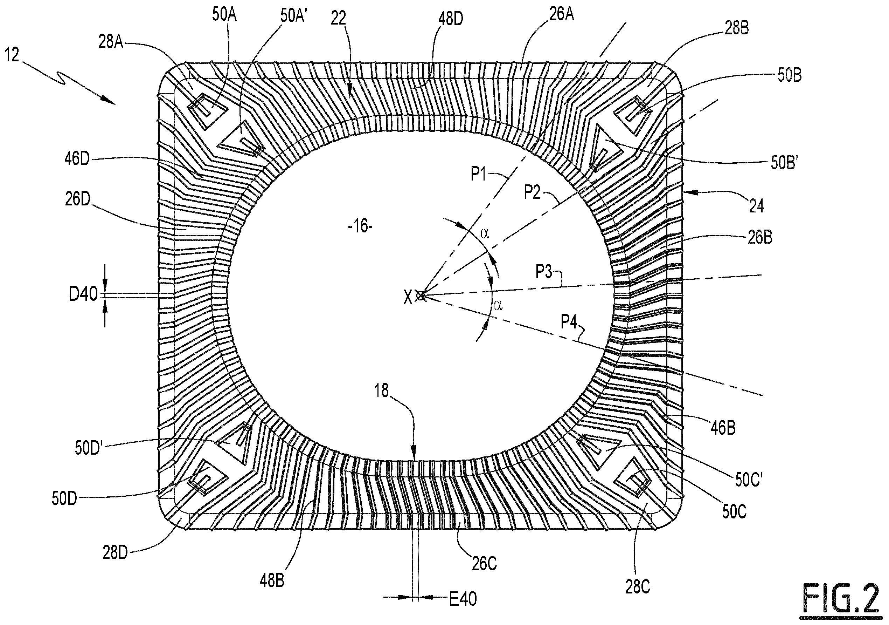

Comme montré sur les figures 1 et 2, structurellement, l'armature 12 présente une forme générale de boucle fermée entourant l'axe principal X, ou plus généralement une forme annulaire, délimitant en son centre une ouverture centrale 16, qui est traversante et par laquelle passe l'axe principal X. L'ouverture centrale 16 s'étend selon l'axe principal X, de sorte que l'ouverture centrale est en forme de cylindre droit, circulaire ou non. Dans l'exemple, une section de l'ouverture centrale 16, considérée perpendiculairement à l'axe principal X, est de forme oblongue. En variante non-représentée, la section de l'ouverture 16 présente une autre forme, telle qu'une forme circulaire ou elliptique. L'ouverture centrale 16 délimite une face intérieure 18 de l'armature 12

Dans l'exemple des figures 1 et 2, l'armature 12 a une forme de parallélépipède rectangle, présentant une face supérieure 20 et une face inférieure 22, s'étendant chacune perpendiculairement à l'axe principal X. Ainsi, l'ouverture 16 relie la face supérieure 20 à la face inférieure 22, c'est-à-dire que la face intérieure 18 de l'armature s'étend de la face supérieure à la face inférieure. L'armature 12 présente également une face extérieure 24, qui relie la face supérieure à la face inférieure en s'étendant parallèlement à l'axe principal X. La face extérieure 24, la face supérieure 20 et la face inférieure 22 définissent donc ensemble un volume parallélépipédique rectangle traversé par l'ouverture centrale 16. En variante non-représentée de l'invention, l'armature n'a pas une forme de parallélépipède rectangle, mais une forme prismatique droite.

L'armature 12, mesure par exemple environ 25 mm par 25 mm dans un plan perpendiculaire à l'axe X et environ 5 mm selon l'axe X. Plus généralement, le composant décrit ici présente avantageusement une longueur comprise entre 10 mm et 100 mm, une largeur comprise entre 10 mm et 100 mm, et une hauteur comprise entre 2 mm et 40 mm.

Dans l'exemple, l'armature 12 ayant une forme de parallélépipède rectangle, l'armature comprend quatre bras 26A, 26B, 26C et 26D, connectés entre eux, c'est-à-dire deux à deux, par quatre jointures 28A, 28B, 28C et 28D, les jointures formant des angles de l'armature 12. Ainsi, la face extérieure 24 de l'armature est formée par une face extérieure de chaque bras 26A, 26B, 26C et 26D, c'est-à-dire que chaque bras présente une face extérieure notée respectivement 24A, 24B, 24C et 24D. Les faces extérieures 24A, 24B, 24C et 24D des quatre bras 26A, 26B, 26C et 26D sont planes, et s'étendent ainsi chacune parallèlement à l'axe X. Ici, deux faces extérieures de deux bras adjacents sont perpendiculaires entre elles.

En variante non-représentée de l'invention, l'armature 12 a une autre forme, par exemple une forme prismatique dont la base est un trapèze ou un carré. Quelle que soit la forme de l'armature 12, l'armature présente quatre bras.

La carte de circuit imprimé 14 et l'armature 12 sont superposées, selon l'axe X, de sorte que la face inférieure 22 de l'armature est située en regard de la carte de circuit imprimé. En outre, la carte de circuit imprimé présente un trou central 30, qui est traversé par l'axe X. En pratique, le trou central 30 et l'ouverture centrale 16 sont alignées le long de l'axe X.

En outre, la carte de circuit imprimé 14 comprend quatre branches 32A, 32B, 32C et 32D, qui s'étendent en boucle entourant l'axe X. Avantageusement, chaque branche de la carte de circuit imprimé 14 est aligné avec l'un des bras de l'armature 12, selon l'axe X.

Le composant électrique 10 constitue préférentiellement un capteur de courant. L'intensité du courant d'un conducteur s'étendant essentiellement selon l'axe X, traversant la boucle formée par les quatre bras 26A, 26B, 26C et 26D de l'armature 12 en passant au travers de l'ouverture 16, et traversant la boucle formée par les quatre branches 32A, 32B, 32C et 32D de la carte de circuit imprimé 14 en passant au travers du trou 30, peut être déterminée grâce au composant électrique 10, une tension étant induite aux bornes du composant électrique en fonction du flux magnétique traversant ladite ouverture 16 et ledit trou 30 selon l'axe X. En outre, l'épaisseur de la carte de circuit imprimé 14 étant faible devant l'épaisseur de l'armature 12, on assimile dans la suite de la description le flux magnétique traversant l'ouverture centrale 16 et le trou central 30 au flux magnétique traversant seulement l'ouverture centrale 16.

De préférence, ce composant est de type capteur de Rogowski et la tension induite reflète la valeur de la variation du courant traversant l'ouverture 16.

Le composant électrique 10 est destiné à être connecté à une électronique de capteur, non-représentée, incluant une électronique de conditionnement se présentant par exemple sous la forme d'un circuit intégrateur. En pratique, cette électronique de capteur est soit connectée à la carte de circuit imprimé 14, soit directement embarquée sur la carte de circuit imprimé.

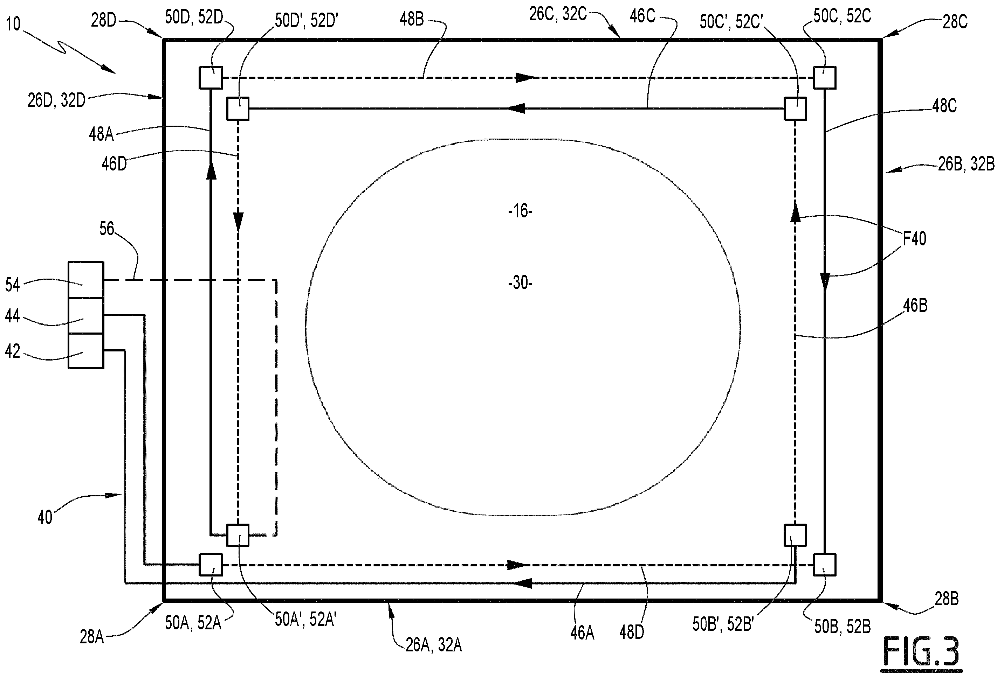

En pratique, le composant électrique 10, en particulier lorsqu'il est de type capteur de Rogowski, comprend une ligne électrique non-ramifiée 40, qui comprend un premier point de connexion 42, un deuxième point de connexion 44 et des segments qui se succèdent depuis le premier point de connexion jusqu'au deuxième point de connexion, selon un sens de circulation F40 de la ligne électrique. La ligne électrique 40 est représentée de manière schématique à la figure 3. De préférence, et comme représenté sur les figures, les premier et deuxième points de connexions sont portés par la carte de circuit imprimé 14. Dans la suite de la description, les termes « amont » et « aval » s'entendent relativement au sens de circulation F40 de la ligne électrique. En outre, il est à noter que le sens de circulation décrit ici est choisi arbitrairement, et, en variante, pourrait donc également être considéré comme allant du deuxième point de connexion vers le premier point de connexion. Ici, le premier point de connexion 42 et le deuxième point de connexion 44 forment donc respectivement une borne d'entrée et une borne de sortie de la ligne électrique 40, et en variante, le premier point de connexion et le deuxième point de connexion forment respectivement une borne de sortie et une borne d'entrée de la ligne électrique.

La ligne électrique 40 s'étend sur les quatre bras de l'armature 12 ainsi que sur les quatre branches de la carte de circuit imprimé 14. En outre, chaque bras de l'armature porte uniquement un segment de la ligne électrique, et chaque branche de la carte de circuit imprimé porte uniquement un segment de la ligne électrique. Ainsi, la ligne électrique 40 présente huit segments, c'est-à-dire quatre segments sur les bras de l'armature et quatre segments sur les branches de la carte de circuit imprimé. Sur la figure 3, on distingue les segments de la ligne électrique 40 portés par la carte de circuit imprimé 14, représentés chacun par un trait plein, des segments de la ligne électrique portés par l'armature 12, représentés chacun par un trait en pointillés courts.

La ligne électrique 40 est un conducteur électrique, de sorte que lorsqu'un conducteur est placé dans les ouvertures 16 et 30 du composant électrique 10, ce conducteur induit une tension dans la ligne électrique, cette tension dépendant du flux magnétique traversant les ouvertures 16 et 30, en étant plus précisément proportionnelle à la valeur de variation du courant dans ledit conducteur. Une tension est ainsi induite aux bornes de la ligne électrique 40, c'est-à-dire entre le premier point de connexion 42 et le deuxième point de connexion 44. Le composant électrique 10 se comporte alors comme un capteur mesurant le changement du courant d'un conducteur placé dans les ouvertures 16, 30.

L'armature étant réalisée en matière plastique polymère et portant une piste conductrices formée par la ligne électrique 40 elle peut être qualifié de composant plastronique.

Comme mieux visible sur les figures 1 et 2, chaque segment de la ligne électrique 40 étant porté par l'un des bras 26A-26D de l'armature 12 décrit des spires s'enroulant autour dudit bras de l'armature, c'est-à-dire se propageant tout autour du bras, le long des faces intérieure 18, supérieure 20, inférieure 22 et extérieure 24 du bras. Ainsi, chacun de ces segments forme un enroulement. En outre, pour chaque bras de l'armature, les spires de la ligne électrique sont présentes sur toute la longueur du bras, c'est-à-dire qu'elles s'étendent entre les deux jointures délimitant ce bras. Autrement dit, la ligne électrique s'enroule en spirale autour des bras de l'armature. La ligne électrique s'étend ainsi selon trois dimensions sur l'armature 12.

À l'inverse, chaque segment de la ligne électrique étant porté par l'une des branches 32A-32D de la carte de circuit imprimé 14 s'étend de manière essentiellement rectiligne sur toute la longueur de ladite branche, c'est-à-dire sans effectuer de spire ou de boucle. La ligne électrique s'étend ainsi selon deux dimensions sur l'armature 12, c'est-à-dire qu'elle s'étend à plat.

On comprend alors que la longueur d'un segment de la ligne électrique 40 porté par l'un des bras de l'armature est bien supérieure à la longueur d'un segment de la ligne électrique porté par l'une des branches de la carte de circuit imprimé.

La ligne électrique 40 étant portée par les bras de l'armature et par les branches de la carte de circuit imprimé, elle s'étend tout autour de l'axe X.

Parmi les huit segments de la ligne électrique 40, on distingue les quatre premiers segments, notés 46A, 46B, 46C et 46D des quatre derniers segments, notés 48A, 48B, 48C et 48D. Les quatre premiers segments 46A à 46D s'étendent autour de l'axe X dans une première direction, par exemple dans le sens trigonométrique, selon le point de vue de la figure 3, de sorte à former une première boucle entourant entièrement l'axe X, et les quatre derniers segments 48A à 48D s'étendent autour de l'axe X dans une deuxième direction opposée à la première direction, par exemple dans le sens anti-trigonométrique, selon le point de vue de la figure 3, de sorte à former une deuxième boucle entourant entièrement l'axe X. Autrement dit, la ligne électrique 40 comporte deux boucles, qui entourent chacune entièrement l'axe X dans des sens opposés. De manière habituelle, on nomme la première boucle formée par les segments 46A-46D « boucle aller » et la deuxième boucle formée par les segments 48A-48D « boucle retour ».

Ainsi, puisque les deux boucles formées par les segments 46A à 46D et 48A à 48D de la ligne électrique 40 entourent entièrement l'axe X dans un premier sens puis dans un deuxième sens, le premier point de connexion 42 et le deuxième point de connexion 44 sont situés à proximité l'un de l'autre, c'est-à-dire qu'ils sont situés au même niveau, dans une direction circonférentielle autour de l'axe X. En particulier, le premier point de connexion 42 et le deuxième point de connexion 44 sont portés par la même branche de la carte de circuit imprimé 14, dans l'exemple par la branche 32B.

La ligne électrique 40 comprend donc des segments distincts 46A-46D et 48A-48D, qui sont reliés entre eux par des jonctions de la ligne électrique. Dans l'exemple, ces jonctions sont formées par des plots de contact, qui sont situés sur la face inférieure 22 de l'armature 12. En pratique, dans le premier mode de réalisation, la ligne électrique 40 comprend huit plots de contact, qui sont portés par les jointures 28A à 28D de l'armature 12, de sorte que chaque jointure de l'armature porte deux plots de contact. Parmi les plots de contact de la ligne électrique, on distingue ainsi deux plots de contact 50A et 50A', disposés au niveau de la jointure 28A, deux plots de contact 50B et 50B', disposés au niveau de la jointure 28B, deux plots de contact 50C et 50C', disposés au niveau de la jointure 28C et deux plots de contact 50D et 50D', disposés au niveau de la jointure 28D. Autrement dit, les plots de contact sont groupés par paire et chaque jointure de l'armature comprend une paire de plots de contact.

Ainsi, chaque segment 46A-46D et 48A-48D de la ligne électrique 40 est connecté au segment suivant de la ligne électrique, selon le sens de circulation F40, par une jonction de la ligne électrique formée par l'un des plots de contact 50A, 50A', 50B, 50B', 50C, 50C', 50D, 50D', le premier segment 46A étant en outre connecté au premier point de connexion 42, qui est situé en amont du premier segment, selon le sens de circulation, et le dernier segment 48D est connecté au deuxième point de connexion 44, qui est situé en aval du dernier segment, selon le sens de circulation.

Comme cela est mieux visible sur la figure 3, dans le premier mode de réalisation, la ligne électrique 40 est enchevêtrée entre l'armature 12 et la carte de circuit imprimé 14, de sorte que, pour deux segments consécutifs de la ligne électrique, un premier est porté par un bras de l'armature et un second est porté par une branche de la carte de circuit imprimé. En outre, dans l'exemple, le premier segment 46A est porté par la carte de circuit imprimé. Ainsi, dans l'exemple, les segments 46A, 46C, 48A et 48C sont portés par la carte de circuit imprimé 14, respectivement par les branches 32A, 32C, 32D et 32B de la carte de circuit imprimé. De plus, les segments 46B, 46D, 48B et 48D sont portés par l'armature 12, respectivement par les bras 26B, 26D, 26C et 26A de l'armature.

On comprend alors que les jonctions de la ligne électrique 40, formées par les plots de contact 50A, 50A', 50B, 50B', 50C, 50C', 50D, 50D', permettent d'assurer la jonction entre deux segments consécutifs de la ligne électrique dont l'un des deux segments consécutifs est porté par un bras de l'armature et dont l'autre des deux segments consécutifs est porté par une branche de la carte de circuit imprimé. Autrement dit, les plots de contact permettent d'assurer une continuité de la ligne électrique 40 entre la carte de circuit imprimé et l'armature.

On remarque que, parmi les plots de contact, le plot de contact 50A' permet d'assurer une connexion électrique entre le dernier segment 46D de la première boucle et le premier segment 48A de la première boucle. Ainsi, au niveau du plot de contact 50A', la ligne électrique 40 change de direction.

On comprend ainsi que la boucle aller et la boucle retour sont des boucles ouvertes, dont les deux extrémités sont situées au niveau des plots de contact 50A, 50A', c'est-à-dire au niveau de la jointure 28A de l'armature 12. Le composant électrique 10 présente ainsi une faible diaphonie, ou encore une bonne immunité, c'est-à-dire que le composant électrique 10 détecte efficacement un conducteur traversant les ouvertures 16 et 30 mais est peu perturbé par un conducteur qui serait situé à l'extérieur des ouvertures 16 et 30, c'est-à-dire à l'extérieur du composant électrique. En effet, la surface susceptible de capter des champs extérieurs est ici réduite à la surface des bras de l'armature 12 et des branches de la carte de circuit imprimé 14 du composant électrique 10, au contraire d'un composant électrique ne comportant pas de conducteurs réalisant un aller-retour, dans lequel la surface susceptible de capter des champs extérieurs correspond à la surface totale du composant, ouvertures comprises.

En outre, on remarque que le premier segment 46A est connecté au premier point de connexion 42 sans qu'un plot de contact ne soit disposé entre le premier point de connexion et le segment. L'absence de plot de contact entre le premier point de connexion et le premier segment est possible, car le premier point de connexion et le premier segment sont tous deux formés sur la carte de circuit imprimé et peuvent donc être directement reliés par une piste électrique de la carte de circuit imprimé. Ainsi, ici, une piste électrique non-ramifiée s'étend entre le premier point de connexion et le premier segment 46A, permettant d'éloigner le premier point de connexion de la branche 32A de la carte de circuit imprimé. En variante non-représentée de l'invention, le premier point de connexion est disposé directement à l'extrémité amont du premier segment 46A.

On remarque que le dernier segment 48D est connecté au deuxième point de connexion 44 par l'intermédiaire du plot de contact 50A. Ce plot de contact est nécessaire pour assurer cette connexion, car le dernier segment 48D est porté par le bras 26A de l'armature 12 alors que le deuxième point de connexion 44 est formé sur la carte de circuit imprimé 14. Ainsi, le plot de contact 50A n'assure pas une connexion entre deux segments consécutifs de la ligne électrique 40. Alternativement, le plot de contact 50A est également dénommé plot de connexion. Ici, une piste électrique non-ramifiée s'étend entre le deuxième point de connexion et plot de contact 50A, permettant d'éloigner le deuxième point de connexion du dernier segment 48D. En variante non-représentée de l'invention, le deuxième point de connexion est formé directement par le plot de contact 50A.

L'enchevêtrement de la ligne électrique 40, dont les segments sont successivement portés par l'armature 12 et par la carte de circuit imprimé 14, est particulièrement avantageux pour améliorer la diaphonie du composant électrique 10, c'est-à-dire son immunité aux perturbations extérieures. En effet, grâce à cet enchevêtrement, la longueur de la première boucle formée par les segments 46A-46D est sensiblement égale à la longueur de la deuxième boucle formée par les segments 48A-48D.

Avantageusement, le composant électrique 10 comprend également un troisième point de connexion 54 et une ligne électrique auxiliaire 56, qui sont portés par la carte de circuit imprimé 14. Comme mieux visible sur la figure 3, la ligne électrique auxiliaire 56 est connectée d'une part au troisième point de connexion 54 et d'autre part au plot de contact 50A', c'est-à-dire à jointure entre le dernier segment 46D de la première boucle et le premier segment 48A de la deuxième boucle de la ligne électrique 40. En variante non-représentée, la ligne électrique auxiliaire 56 n'est pas connectée au plot de contact 50A', mais est connecté directement au segment 46D ou au segment 48A de la ligne électrique 40. En d'autres termes, la ligne électrique auxiliaire est connectée à la ligne électrique entre le quatrième et le cinquième segment de la ligne électrique, c'est-à-dire au centre ou à proximité du centre de la ligne électrique. De préférence, le troisième point de connexion 54 est également représenté à un point de masse non-représenté de la carte de circuit imprimé 14, c'est-à-dire à un point de connexion dont la tension est égale à OV. La présence du troisième point de connexion 54 et de la ligne électrique auxiliaire 56 est particulièrement avantageuse, car elle permet, lorsque le composant électrique 10 est utilisé comme un capteur de Rogowski, de réaliser de la mesure différentielle permettant d'améliorer la précision de mesure du composant électrique et d'éviter des phénomènes capacitifs d'interaction entre la ligne électrique 40 et le conducteur passant par les ouvertures 16, 30. Notamment, la précision de mesure du capteur est améliorée, car une conversion du signal analogique provenant du capteur en signal numérique est plus précis, le signal analogique pouvant alors être recentré autour d'une valeur nulle, ce qui permet de limiter des phénomènes de saturation du signal. Le positionnement de la ligne électrique auxiliaire 56 décrit ici est particulièrement avantageux, car en étant connectée au centre de la ligne électrique 40, les performances du composant électrique 10 sont optimisées.

L'utilisation combinée de l'armature 12 fabriquée par plastronique, sur laquelle une partie des segments de la ligne électrique 40 sont formés, et de la carte de circuit imprimé 14, sur laquelle une autre partie des segments de la ligne électrique 40 sont formés, est particulièrement avantageuse en ce qu'elle permet d'obtenir une boucle aller et une boucle retour dont les dimensions des segments portés par l'armature sont maximisées, permettant ainsi la formation d'un capteur de courant de type Rogowski particulièrement compact et performant, dont les performances sont ainsi optimisées, avec un gain et une précision élevée, sans subir de saturation.

Un autre avantage de l'invention est de permettre de facilement intégrer le composant électrique 10 à un circuit électrique, car la carte de circuit imprimé 14 peut facilement être fixée sur une autre carte de circuit imprimé, par exemple par soudure, ou bien connectée à une autre carte de circuit imprimé par des fils électriques. En outre, le composant électrique peut également être directement intégré à un circuit électrique, en intégrant les différents éléments portés par la carte de circuit imprimé 14 à une autre carte de circuit imprimé.

Le composant électrique 10 des figures 1 à 3 est obtenu à l'aide du procédé de fabrication défini ci-dessous.

Pour l'essentiel, le procédé de fabrication comprend successivement une fourniture ou une fabrication de l'armature 12, puis une gravure par laser de l'armature 12, puis un traitement chimique de l'armature 12 incluant une métallisation, pour former la ligne électrique 40, puis un assemblage de l'armature 12 sur la carte de circuit imprimé 14.

La fabrication de l'armature 12 comprend préférentiellement un moulage de l'armature par injection du matériau dans un moule, alors que le matériau est dans un état visqueux. Le moule est configuré pour conformer, en une seule opération de moulage, toutes les parties de l'armature 12.

Une fois l'armature 12 fabriquée, on procède à la gravure par laser de l'armature. En particulier, sur toutes les faces 18, 20, 22 et 24 de l'armature, et sur les quatre bras 26A-26D de l'armature, on effectue une gravure par laser d'une piste d'amorce, qui servira plus tard de base pour la formation des segments de la ligne électrique 40 portés par l'armature.

Le matériau de l'armature 12 est spécialement prévu pour permettre la formation de la piste d'amorce par gravure laser, par exemple à l'aide de tout graveur laser approprié. Par « graveur laser », on entend par exemple un appareil comprenant à la fois une source d'un faisceau laser, des moyens pour orienter le faisceau laser, par exemple un jeu de miroirs orientables, et des moyens pour focaliser le faisceau laser, tel qu'un jeu de lentilles.

L'application du laser localement sur la surface du matériau conduit à la formation de la piste d'amorce, qui peut être dessinée, avec tout tracé souhaité, par application du laser. La gravure laser vise à former la piste d'amorce sur l'armature 12 de sorte que la piste d'amorce a exactement le même tracé que les segments de la ligne électrique 40 portés par l'armature. La piste d'amorce s'enroule en spirale autour de l'armature 12, afin de former une succession de spires qui constitueront les segments 46B, 46D, 48B et 48D de la ligne électrique 40 à une étape ultérieure du procédé. Ces segments forment donc des enroulements. La piste d'amorce se distingue du reste de la surface de l'armature 12 en ce qu'elle est constituée par des parties activées de l'additif organométallique, alors que l'additif organométallique est dans un état non activé pour le reste de l'armature. De plus, la piste d'amorce se distingue du reste de la surface de l'armature 12 en ce qu'elle forme un sillon, ou pour le moins en ce qu'elle présente un état de surface plus abrasif.

De préférence, l'additif organométallique est formé par un complexe métallique comprenant un noyau métallique, par exemple un noyau de cuivre, qui, dans l'état non-activé, est lié par liaison covalente à la matière plastique polymère. Cet additif organométallique est apte à être activé sélectivement, en surface de l'armature, par application locale et sélective d'un rayonnement laser approprié, par exemple un rayonnement laser infrarouge pulsé. Pour activer l'additif organométallique, le rayonnement laser brise le complexe, ce qui libère le noyau métallique seulement à l'endroit où le rayonnement est appliqué. Plus précisément, le laser entraîne une réduction du métal du complexe, le noyau se présentant alors sous forme métallique, ici du cuivre métallique. En outre, le rayonnement laser chauffe localement la surface du matériau entraîne une augmentation locale de la rugosité de la surface, par ablation partielle de la matière plastique polymère.

De préférence, une fois la gravure par laser effectuée, on effectue un nettoyage de l'armature 12 pour retirer tout débris causé par cette opération.

La pistes d'amorce ainsi gravée n'est pas suffisamment conductrice d'électricité pour que le composant électrique 10 puisse fonctionner. On procède donc au traitement chimique de l'armature 12 pour faire croître cette piste d'amorce.

Le traitement chimique consiste en premier lieu en une métallisation de la piste d'amorce, pour former les segments 46B, 46D, 48B et 48D de la ligne électrique 40, directement en surface de l'armature 12. La métallisation entraîne une croissance de la piste d'amorce, alors que le reste de la surface de l'armature 12 reste électriquement isolante.

Par « métallisation », on entend par exemple une métallisation autocatalytique. On plonge l'armature portant la piste d'amorce dans une solution comprenant des ions métalliques du métal avec lequel on souhaite former les pistes conductrices, par exemple du cuivre. Par exemple, la solution comprend un sel métallique contenant les ions métalliques, ici les ions cuivre, un agent réducteur pour la réduction des ions métalliques. Par réaction d'oxydo-réduction, le métal des ions métalliques se déposent seulement sur la piste d'amorce sans se déposer sur le reste de la surface de l'armature 1, la piste d'amorce constituant un catalyseur de la réaction d'oxydo-réduction. La couche de métal déposée par ce procédé constitue un catalyseur pour le dépôt de davantage de métal par oxydoréduction. C'est ainsi que croit les segments 46B, 46D, 48B et 48D de la ligne électrique 40 par la métallisation. Mécaniquement, les segments de la ligne électrique ainsi formés sont fortement solidaire du matériau plastique polymère en s'ancrant mécaniquement aux aspérités constituées par le caractère abrasif de la surface de l'armature 12, du fait de la gravure par laser.

De préférence, une fois les segments 46B, 46D, 48B et 48D de la ligne électrique 40 formés par la métallisation, les traitements chimiques incluent le dépôt de couches de finition pour protéger ces segments. À cette fin, par exemple, on met en oeuvre un procédé de type ENIG (en anglais « Electroless Nickel Immersion Gold »). Pour cela, on applique d'abord une couche de nickel-phosphore par métallisation autocatalytique sur la face libre de la piste conductrice, c'est-à-dire la face opposée à la surface de l'armature 12. Cette métallisation autocatalytique est avantageusement effectuée après que les pistes conductrices en cuivre aient été activées au palladium. Ensuite, on applique une couche d'or externe, par exemple par déplacement chimique. La couche d'or empêche l'oxydation des pistes conductrices recouvertes, alors que la couche de nickel-phosphate empêche la migration de l'or vers le cuivre.

À l'issue des traitements chimiques pour former les segments 46B, 46D, 48B et 48D de la ligne électrique 40, la fabrication de l'armature 12 est terminée.

En parallèle de la fabrication de l'armature 12, on fabrique ou on fournit la carte de circuit imprimé 14 selon des procédés connus par ailleurs, de sorte à former sur la carte de circuit imprimé les segments 46A, 46C, 48A et 48C de la ligne électrique 40, ainsi que les premier, deuxième et éventuellement troisième points de connexion 42, 44 et 54.

Après la fabrication de l'armature 12 et de la carte de circuit imprimé 14, on vient assembler l'armature et la carte de circuit imprimé l'une à l'autre, pour former le composant électrique 10. Cet assemblage s'effectue en deux étapes.

Une première étape est de positionner l'armature sur la carte de circuit imprimé, de sorte à mettre les plots de contact 50A, 50A', 50B, 50B', 50C, 50C', 50D, 50D' en contact avec les extrémités des segments 46A, 46C, 48A et 48C de la ligne électrique 40, et de sorte à aligner l'ouverture 16 de l'armature avec l'ouverture 30 de la carte de circuit imprimé, selon l'axe X.

Une deuxième étape est de fixer l'armature à la carte de circuit imprimé, en soudant les plots de contact 50A, 50A', 50B, 50B', 50C, 50C', 50D, 50D' à la carte de circuit imprimé, et plus particulièrement aux extrémités des segments 46A, 46C, 48A et 48C de la ligne électrique 40. Avantageusement, grâce à cette méthode de fixation, les plots de contact assurent la tenue mécanique de l'armature 12 sur la carte de circuit imprimé 14, en plus d'assurer la continuité électrique de la ligne électrique 40.

À l'issue de cette étape, le composant électrique 10 est alors terminé.

De manière particulièrement avantageuse, la soudure des plots de contact sur la carte de circuit imprimé s'effectue en utilisant un four de refusion par convection dans lequel le composant électrique 10 est placé. Cette refusion par convection permet d'obtenir une bonne tenue mécanique de l'armature 12 sur la carte de circuit imprimé, limitant ainsi les risques de dégradation du composant électrique 10, par exemple les risques d'arrachement de l'armature 12, tout en obtenant simultanément une bonne connexion électrique entre les plots de contact et les segments de la ligne électrique portés par la carte de circuit imprimé. En outre, cette méthode de soudage permet de limiter des contraintes appliquées à la carte de circuit imprimé, et permet donc de limiter le risque de décollement ou de fissuration des segments de la ligne électrique 10 portés par la carte de circuit imprimé.

Grâce au procédé de fabrication, et en particulier grâce à l'étape de refusion par convection, la fabrication du composant électrique 10 est entièrement automatisée. Notamment, l'armature 12 peut être positionnée puis fixée à la carte de circuit imprimé 14 de manière entièrement automatisée, facilitant la fabrication du composant électrique 10 et garantissant une bonne fiabilité dans le positionnement de l'armature 12 sur la carte de circuit imprimé 14.

Comme visible sur la figure 1, dans l'exemple, la carte de circuit imprimé 14 présente des zones de contact 52A, 52A', 52B, 52B', 52C, 52C', 52D, 52D', qui appartiennent à la ligne électrique 40 et qui sont disposées respectivement en regard, selon l'axe X, des plots de contact 50A, 50A', 50B, 50B', 50C, 50C', 50D, 50D'. En pratique, les zones de contact sont prévues pour élargir les segments de la ligne électrique formés sur la carte de circuit imprimé au niveau de leurs extrémités, et pour faciliter la connexion entre ces segments et les plots de contact. En variante non-représentée de l'invention, la carte de circuit imprimé ne présente pas de telles zones de contact.

La fabrication décrite ci-dessus est particulièrement avantageuse pour obtenir un composant électrique 10 avec une grande densité de spires, dont les spires sont en outre de grande taille. Le positionnement des spires est en outre particulièrement bien maîtrisé, ce qui assure une performance optimale du composant électrique.

De plus, grâce au procédé de fabrication de l'armature 12, la largeur de la ligne électrique 40 portée par l'armature 12, mesurée de la même manière, notée D40, est avantageusement inférieure à 400 µm, voire inférieure à 200 µm. De préférence, la largeur D40 est égale à 100 µm. La ligne électrique 40 étant très fine, elle est représentée avec une épaisseur supérieure à son épaisseur réelle aux figures 1 et 2. En d'autres termes, la ligne électrique n'est pas représentée à l'échelle sur les figures 1 et 2.

En outre, grâce au procédé de fabrication de l'armature 12, la distance minimale séparant deux spires adjacentes d'un segment de la ligne électrique 40 porté par un bras 26A-46D de l'armature 12, mesurée sur la face extérieure 24A-24D de ce bras perpendiculairement à l'axe X, notée E40, est inférieure à 400 µm, de préférence inférieure à 200 µm. De préférence, la distance minimale E40 est égale à 100 µm.

On peut donc obtenir une densité de spires très élevée sur l'armature 12, par exemple de plusieurs spires par millimètre, ainsi qu'un tracé très précis de la piste conductrice 40. De plus, la section des bras de l'armature, et donc la section des spires s'enroulant autour des bras de l'armature, peut être rendue très grande en prévoyant que l'armature 12 présente toute forme souhaitée. En effet, au niveau des bras de l'armature, la piste conductrice 40 étant formée directement en surface de l'armature, c'est la forme de la section de l'armature 12 qui détermine la géométrie de la section transversale de chaque spire et donc l'enveloppe des segments de la piste conductrice portés par l'armature. En particulier, pour chaque spire, la section transversale de la spire correspond au contour extérieur de l'armature 12, vu dans le plan de la spire. Ici, compte-tenu de la forme de l'armature 12, il en résulte que chaque spire est de forme rectangulaire.

La section des bras 26A-26D de l'armature peut présenter une largeur mesurée perpendiculairement à l'axe X et à la face extérieure 24, ou sinon une grandeur caractéristique telle qu'une diagonale, qui est supérieur à 1 mm, par exemple 5 mm, voire supérieur à 5 mm. Ainsi, chaque spire peut présenter une circonférence d'environ 4 mm au minimum. À titre d'exemple, l'armature, sur ses quatre bras, peut porter une centaine de spires. La longueur cumulée des segments de la ligne électrique 40 portés par l'armature 12, peut par exemple être comprise entre 400 et 8 000 mm. En comparaison, la longueur cumulée des segments de la ligne électrique portés par la carte de circuit imprimé 14 peut par exemple être comprise entre 10 mm et 400 mm.

La grande taille et densité de spires pouvant être obtenue grâce au composant électrique de l'invention permet d'obtenir un rapport signal / bruit supérieur à celui des capteurs connus. En d'autres termes, le gain et la précision du composant électrique sont améliorés par rapport aux capteurs connus.

En outre, et comme cela est mieux visible sur la figure 2, la distance séparant deux spires adjacentes d'un segment de la ligne électrique 40 porté par un bras 26A-46D de l'armature 12 est variable le long dudit bras. Autrement dit, le pas de l'enroulement formé par les spires portées par un bras est un pas variable, et la valeur minimale de ce pas est égale à E40. En effet, les spires sont plus resserrées au niveau du centre des bras 26A-26D qu'à proximité des jointures 28A-28D. De plus, puisque l'armature 12 est de forme parallélépipédique, les spires situées aux jointures 28A-28D de l'armature sont de plus grande taille que les spires situées aux centres des bras 26A-26D de l'armature.

La ligne électrique 40 est avantageusement conçue de sorte que la variabilité de l'écartement des spires et la variabilité de la taille des spires coopèrent ensemble de sorte que le flux capté par une portion des segments de la ligne électrique 40 portés par l'armature est globalement constant quelle que soit la portion considérée de la ligne électrique, ce qui permet d'obtenir une bonne diaphonie malgré la forme rectangulaire du composant électrique 10. Les performances du composant électrique 10 en tant que capteur sont ainsi indépendantes de l'orientation du composant électrique autour de l'axe X.

À titre d'exemple, on définit une première portion de l'armature et une deuxième portion de l'armature. La première portion de l'armature est délimitée entre un premier plan P1 radial passant par l'axe X et un deuxième plan radial P2 passant par l'axe X et décalé du premier plan radial d'un angle α. La deuxième portion de l'armature est délimitée entre un troisième plan P3 radial passant par l'axe X et un quatrième plan radial P4 passant par l'axe X et décalé du troisième plan radial d'un angle α. L'angle de décalage α est identique pour la première portion de l'armature et pour la deuxième portion de l'armature. Ici, on remarque que la première portion de l'armature est centrée autour de la jointure 28B et que la deuxième portion de l'armature est située au niveau du bras 26B de l'armature. En pratique, pour obtenir une bonne diaphonie, l'écartement des spires est prévu de sorte qu'une surface cumulée des spires comprises dans la première portion de l'armature diffère d'une surface cumulée des spires comprises dans la deuxième portion de l'armature de moins de 5%, de préférence de moins de 2%, quel que soit l'angle α, pour un angle α au moins égal à 10°. Plus cette différence est faible, plus l'immunité du composant électrique 10 est bonne et plus les performances du composant électrique sont indépendantes de la position du conducteur dans les ouvertures 16 et 30.

De plus, le fait que les spires de la ligne électrique 40 sont plus écartées au niveau des jointures 28A-28D est particulièrement avantageux pour faciliter la fabrication de l'armature 12, en facilitant le positionnement des plots de contact 50A-50D et 50A'-50D'. En particulier, et comme mieux visible sur la figure 2, les spires sont localement décalées au niveau de la face inférieure 22 de l'armature 12 pour accommoder la présence des plots de contact. Il en résulte que le positionnement des plots de contact au niveau des jointures 28A-28D de l'armature ne dégrade pas de manière significative la diaphonie du composant électrique 10.

En outre, le composant électrique 10 ne comprenant pas de partie ferromagnétique, il n'est pas soumis aux perturbations générées par des champs magnétiques extérieurs au composant électrique, c'est-à-dire qu'il n'est pas sensible à ces champs magnétiques extérieurs.

En variante non-représentée de l'invention, le composant électrique 10 ne forme pas un capteur de type Rogowski, mais un autre type de composant électrique, comme par exemple une antenne, tel qu'une antenne planaire ou non-planaire.

Dans l'exemple décrit ci-dessus, l'armature 12 et la carte de circuit imprimé 14 comprennent respectivement quatre bras et quatre branches. La forme de parallélépipède rectangle du composant électrique 10 qui en résulte est particulièrement avantageuse pour améliorer la compacité du composant électrique et faciliter son intégration dans un circuit électronique. En variante non-représentée de l'invention, l'armature 12 et la carte de circuit imprimé 14 comprennent chacun un nombre différent de bras et de branches, par exemple cinq, six ou huit bras et branches. Un nombre de bras et de branches supérieur à quatre permet d'enchevêtrer davantage la ligne électrique 40 et donc d'améliorer les performances du composant électrique.

Dans l'exemple décrit ci-dessus, la ligne électrique 40 comprend deux boucles connectées en série, à savoir une boucle aller et une boucle retour, faisant chacune un tour complet autour de l'axe X, en étant portées par l'armature 12 et la carte de circuit imprimé 14. En variante non-représentée de l'invention, la ligne électrique 40 comprend quatre demi-boucles, connectées en série, à savoir une première demi-boucle aller faisant un demi-tour autour de l'axe X, dans une première direction par rapport aux premier et deuxième points de connexion 42, 44, puis une première demi-boucle retour, puis une deuxième demi-boucle aller, faisant un demi-tour autour de l'axe X, dans une deuxième direction opposée à la première direction, puis une deuxième demi-boucle retour. Dans une telle variante, on remarque que la ligne électrique 40 forme toujours une boucle aller et une boucle retour, mais que les points de connexion 42, 44 ne sont pas disposés à une extrémité de ces boucles, mais plutôt au centre de ces boucles.

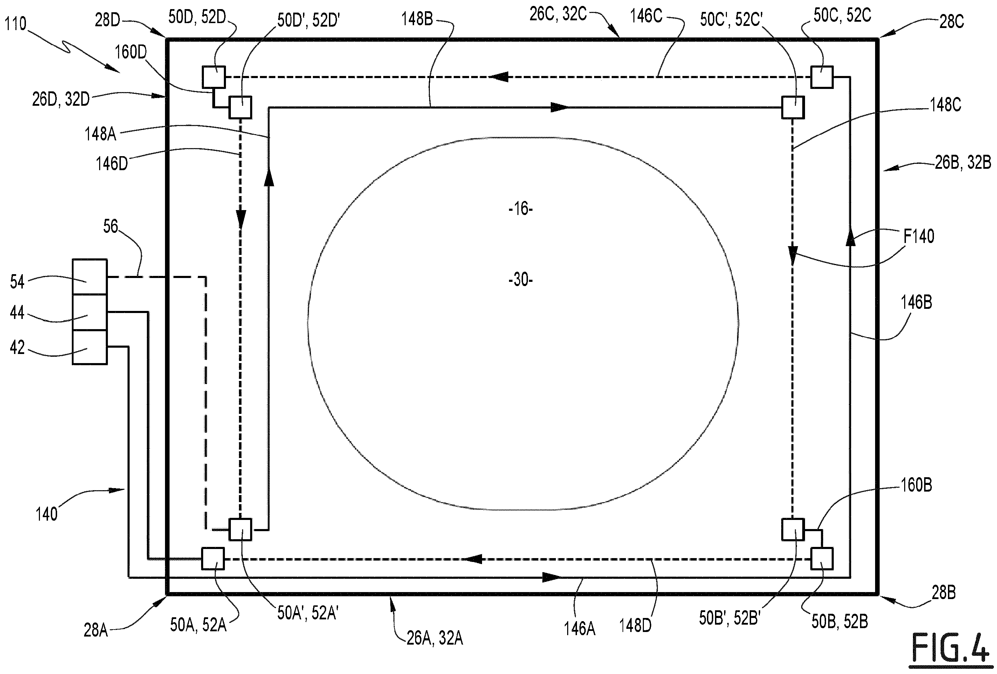

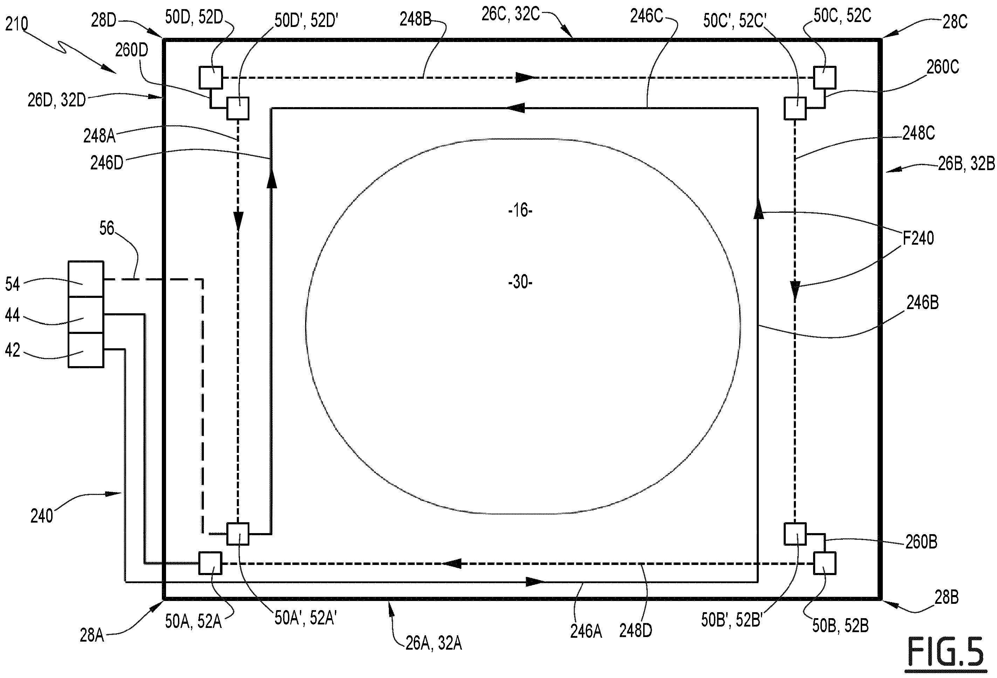

Un deuxième et un troisième mode de réalisation du composant électrique, notés respectivement 110 et 210, sont représentés respectivement sur la figure 4 et sur la figure 5. Dans les deuxième et troisième modes de réalisation, les éléments identiques à ceux du premier mode de réalisation portent les mêmes références et les éléments analogues à ceux du premier mode de réalisation portent les mêmes références augmentées respectivement de 100 ou de 200. Les composants électriques des deuxième et troisième modes de réalisation et leur procédé de réalisation sont identiques à ceux du premier mode de réalisation des figures 1 à 3, hormis pour les différences mentionnées ci-dessous. Dans ce qui suit, on décrit principalement les différences entre les premier, deuxième et troisième modes de réalisation.

En outre, si un composant est mentionné dans la description du deuxième ou du troisième mode de réalisation sans être représenté sur la figure 4 ou sur la figure 5, il correspond au même élément représenté sur les figures 1 à 3 pour le premier mode de réalisation.

Dans le deuxième mode de réalisation, l'armature 12 et la carte de circuit imprimé 14 sont identiques à ceux du premier mode de réalisation. À la différence du premier mode de réalisation, les segments de la ligne électrique 140 n'alternent pas entre un segment porté par la carte de circuit imprimé et un segment porté par l'armature, mais entre deux segments portés par la carte de circuit imprimé et deux segments portés par l'armature. Ainsi, dans le sens de circulation F140 de la ligne électrique 140, on distingue, dans cet ordre : deux segments 146A, 146B portés par la carte de circuit imprimé, puis deux segments 146C, 146D portés par l'armature, ces quatre segments formant la première boucle de la ligne électrique, puis deux segments 148A, 148B portés par la carte de circuit imprimé, puis deux segments 148C, 148D portés par l'armature, ces quatre segments formant la deuxième boucle de la ligne électrique.

Dans le deuxième mode de réalisation, comme dans le premier mode de réalisation, l'armature 12 présente huit plots de contact. Cependant, comme cela ressort de la figure 4, certains plots de contact ne sont pas prévus pour assurer une connexion entre un segment de la ligne électrique porté par l'armature et un segment porté par la carte de circuit imprimé, mais sont au contraire prévus pour assurer une connexion entre deux segments consécutifs de la ligne électrique portés par l'armature. Ainsi, dans l'exemple, les segments 146C et 146D de la ligne électrique sont connectés entre eux par les plots de contact 50D, 50D', et les segments 148C et 148D sont connectés entre eux par les plots de contact 50B, 50B'. En d'autres termes, dans le deuxième mode de réalisation, les plots de contact 50B, 50B', 50D et 50D' ne servent pas à enchevêtrer la ligne électrique 40 entre l'armature 12 et la carte de circuit imprimé 14, mais assurent toutefois la tenue mécanique de l'armature sur la carte de circuit imprimé. Ces plots de contact sont alternativement dénommés plots de connexion.

Dans l'exemple de la figure 4, les plots de contact 50D et 50D' sont reliés entre eux par une broche 160D, formée sur la carte de circuit imprimé 14. De la même manière, les plots de contact 50B et 50B' sont également reliés entre eux par une broche 160B formée sur la carte de circuit imprimé. En variante non-représentée de l'invention, la ligne électrique 140 ne comprend pas de plots de connexion 50B, 50B', 50D, 50D' et les segments 146C et 146D, d'une part, et les segments 148C et 148D, d'autre part, sont reliés entre eux directement par une broche formée en surface de l'armature 12. Alternativement, les spires formées sur l'armature 12 sont ininterrompues entre les segments 146C et 146D, d'une part, et entre les segments 148C et 148D, d'autre part. Autrement dit, dans une telle variante, certaines des jonctions de la ligne électrique ne sont pas formées par des plots de contact, et formalisent seulement le passage entre deux segments consécutifs formés en surface de l'armature 12, n'étant pas physiquement distinctes des spires desdits deux segments. Dans une telle variante, des moyens de fixation complémentaires de l'armature sur la carte de circuit imprimé peuvent être prévus.

On comprend alors que les jonctions de la ligne électrique entre deux segments consécutifs portés par la carte de circuit imprimé 14, et notamment entre les segments 146A et 146B d'une part et les segments 148A et 148B d'autre part sont formées par une partie de la piste conductrice formée sur la carte de circuit imprimé 14, qui est par exemple en force de coude. Ainsi, ces jonctions formalisent seulement le passage entre deux segments consécutifs formés en surface de la carte de circuit imprimé et ne sont pas physiquement distinctes de la piste conductrice.

Dans le troisième mode de réalisation, l'armature 12 et la carte de circuit imprimé 14 sont identiques à ceux du premier mode de réalisation. À la différence du premier mode de réalisation, les segments de la ligne électrique 240 n'alternent pas entre un segment porté par la carte de circuit imprimé et un segment porté par l'armature, mais entre quatre segments portés par la carte de circuit imprimé et quatre segments portés par l'armature. Ainsi, dans le sens de circulation F240 de la ligne électrique 240, on distingue, dans cet ordre : quatre segments 246A à 246D portés par la carte de circuit imprimé, ces quatre segments formant la première boucle de la ligne électrique puis quatre segments 248A à 248D portés par l'armature, ces quatre segments formant la deuxième boucle de la ligne électrique.

Dans le troisième mode de réalisation, comme dans le premier mode de réalisation, l'armature 12 présente huit plots de contact. Cependant, comme cela ressort de la figure 5, certains plots de contact ne sont pas prévus pour assurer une connexion entre un segment de la ligne électrique porté par l'armature et un segment porté par la carte de circuit imprimé, mais sont au contraire prévus pour assurer une connexion entre deux segments consécutifs de la ligne électrique portés par l'armature. Ainsi, dans l'exemple, les segments 248A et 248B sont connectés entre eux par les plots de contact 50D, 50D', les segments 248B et 248C sont connectés entre eux par les plots de contact 50C, 50C', et les segments 248C et 248D sont connectés entre eux par les plots de contact 50B, 50B'. En d'autres termes, dans le deuxième mode de réalisation, les plots de contact 50B, 50B', 50C, 50C', 50D et 50D' ne servent pas à enchevêtrer la ligne électrique 40 entre l'armature 12 et la carte de circuit imprimé 14, mais assurent toutefois la tenue mécanique de l'armature sur la carte de circuit imprimé. Ces plots de contact sont alternativement dénommés plots de connexion.

De manière analogue au deuxième mode de réalisation, dans l'exemple de la figure 5, les plots de contact 50B et 50B' sont reliés entre eux par une broche 260B, formée sur la carte de circuit imprimé 14, les plots de contact 50C et 50C' sont reliés entre eux par une broche 260C formée sur la carte de circuit imprimé et les plots de contact 50D et 50D' sont reliés entre eux par une broche 260D formée sur la carte de circuit imprimé. En variante non-représentée de l'invention, la ligne électrique 240 ne comprend pas de plots de connexion 50B, 50B', 50C, 50C', 50D, 50D', et les segments 248A, 248B, 248C et 248D sont reliés entre eux directement par des broches formées en surface de l'armature 12, ou bien les spires formées sur l'armature 12 sont ininterrompues entre les segments 248A, 248B, 248C et 248D, c'est-à-dire que toutes les spires de l'armature 12 sont connectées entre elles. On comprend alors que les jonctions de la ligne électrique entre deux segments consécutifs portés par l'armature 12 formalisent seulement le passage entre deux segments consécutifs, et ne sont pas physiquement distinctes des spires desdits segments consécutifs. En outre, les segments 246A, 246B, 246C et 246D sont de préférence formés par une piste ininterrompue de la carte de circuit imprimé 14. Autrement dit, dans une telle variante, certaines des jonctions de la ligne électrique ne sont pas formées par des plots de contact. Dans une telle variante, des moyens de fixation complémentaires de l'armature sur la carte de circuit imprimé peuvent être prévus.

On comprend alors que les jonctions de la ligne électrique entre deux segments consécutifs portés par la carte de circuit imprimé 14, et notamment entre les segments 246A 246B, 246C et 246D sont formées par une partie de la piste conductrice formée sur la carte de circuit imprimé 14, qui est par exemple en force de coude. Ainsi, ces jonctions formalisent seulement le passage entre deux segments consécutifs formés en surface de la carte de circuit imprimé et ne sont pas physiquement distinctes de la piste conductrice.

Toute caractéristique décrite dans ce qui précède pour un mode de réalisation ou une variante peut être mise en oeuvre pour les autres modes de réalisation et variantes décrits dans ce qui précède.

## Revendications

1. Composant électrique (10 ; 110 ; 210), comprenant :
- une armature (12), qui est formée par un matériau comprenant une matière plastique polymère et un additif organométallique, l'armature délimitant une ouverture centrale (16), laquelle traverse l'armature selon un axe principal (X),
- une carte de circuit imprimé (14), sur laquelle l'armature (12) est fixée, la carte de circuit imprimé et l'armature étant superposées selon l'axe principal (X), et
- une ligne électrique (40) non-ramifiée, qui comprend un premier point de connexion (42), un deuxième point de connexion (44) et des segments (46A, 46B, 46C, 46D, 48A, 48B, 48C, 48D) qui se succèdent depuis le premier point de connexion jusqu'au deuxième point de connexion, selon un sens de circulation (F40) de la ligne électrique, chaque segment étant porté soit par l'armature, soit par la carte de circuit imprimé, chaque segment étant connecté au segment suivant par une jonction (50A, 50A', 50B, 50B', 50C, 50C', 50D, 50D') respective appartenant à la ligne électrique,
**caractérisé en ce que** l'armature (12) comprend :
- au moins quatre bras (26A, 26B, 26C, 26D), les au moins quatre bras étant répartis en boucle autour de l'ouverture centrale (16), chaque bras de l'armature formant une face extérieure (24A, 24B, 24C, 24D) respective appartenant à l'armature et s'étendant parallèlement à l'axe principal (X) et chaque bras (26A, 26B, 26C, 26D) portant un seul des segments (46B, 46D, 48B, 48D) de la ligne électrique, et
- au moins quatre jointures (28A, 28B, 28C, 28D), chaque bras étant relié au bras adjacent par l'intermédiaire de l'une des jointures,
**en ce que** la carte de circuit imprimé (14) comprend au moins quatre branches (32A, 32B, 32C, 32D), les au moins quatre branches étant réparties en boucle autour de l'axe principal et délimitant un trou central, traversé par l'axe principal (X), chaque branche (32A, 32B, 32C, 32D) de la carte de circuit imprimé (14) portant un seul des segments (46A, 46C, 48A, 48C) de la ligne électrique (40),
**en ce que** :
- le premier point de connexion (44) de la ligne électrique est connecté au premier segment (46A) de la ligne électrique, selon le sens de circulation (F40), le premier segment étant porté par l'une des branches (32A) de la carte de circuit imprimé (14), et
- le dernier segment (48D) de la ligne électrique, selon le sens de circulation, est connecté au deuxième point de connexion (44), le dernier segment étant porté par un bras (26A) de l'armature (12),
et **en ce que** :
- le composant électrique (10) comprend des plots de contact (50A, 50A', 50B, 50B', 50C, 50C', 50D, 50D') portés par l'armature (12) et disposés chacun à l'une des jointures (28A, 28B, 28C, 28D) de l'armature, et
- chaque jonction entre deux segments consécutifs de la ligne électrique, dont l'un des deux segments consécutifs est porté par un bras de l'armature et dont l'autre des deux segments consécutifs est porté par une branche de la carte de circuit imprimé, est formée par l'un des plots de contact.

2. Composant électrique (10 ; 110 ; 210) selon la revendication 1, dans lequel les plots de contact (50A, 50A', 50B, 50B', 50C, 50C', 50D, 50D') sont groupés par paires, une jointure (28A, 28B, 28C, 28D) de l'armature (12) portant soit une paire de plots de contact, soit aucun plot de contact.

3. Composant électrique (10 ; 110 ; 210) selon la revendication 2, dans lequel le composant électrique comprend quatre paires de plots de contact (50A, 50A', 50B, 50B', 50C, 50C', 50D, 50D'), et dans lequel les segments (46A, 46B, 46C, 46D, 48A, 48B, 48C, 48D) de la ligne électrique (40), selon le sens de circulation (F40), alternent entre un segment porté par une branche (32A, 32B, 32C, 32D) de la carte de circuit imprimé (14) et un segment porté par un bras (26A, 26B, 26C, 26D) de l'armature (12).

4. Composant électrique (10 ; 110 ; 210) selon la revendication 2, dans lequel le composant électrique comprend au moins deux paires de plots de contact (50A, 50A', 50C, 50C'), et dans lequel les segments (146A, 146B, 146C, 146D, 148A, 148B, 148C, 148D) de la ligne électrique (140), selon le sens de circulation (F140), alternent entre deux segments consécutifs portés chacun par une branche (32A, 32B, 32C, 32D) de la carte de circuit imprimé (14) et deux segments consécutifs portés chacun par un bras (26A, 26B, 26C, 26D) de l'armature (12).

5. Composant électrique (10 ; 110 ; 210) selon la revendication 2, dans lequel le composant électrique comprend au moins une paire de plots de contact (50A, 50A'), et dans lequel les segments (246A, 246B, 246C, 246D, 248A, 248B, 248C, 248D) de la ligne électrique (240), selon le sens de circulation (F240), alternent entre quatre segments consécutifs portés chacun par une branche (32A, 32B, 32C, 32D) de la carte de circuit imprimé (14) et quatre segments consécutifs portés chacun par un bras (26A, 26B, 26C, 26D) de l'armature (12).

6. Composant électrique (10 ; 110 ; 210) selon l'une des revendications 1 à 5, dans lequel le composant électrique (10 ; 110 ; 210) comprend une ligne électrique auxiliaire (56), portée par la carte de circuit imprimé (14), et dans lequel la ligne électrique auxiliaire est connectée à la ligne électrique (40) entre le quatrième segment (146D) et le cinquième segment (14DA) de la ligne électrique.

7. Composant électrique (10 ; 110 ; 210) selon l'une des revendications 1 à 6, dans lequel l'armature (12) est fixée sur la carte de circuit imprimé (14) par l'intermédiaire des plots de contact (50A, 50A', 50B, 50B', 50C, 50C', 50D, 50D').

8. Composant électrique (10 ; 110 ; 210) selon l'une des revendications 1 à 7, dans lequel chaque segment (46B, 46D, 48B, 48D) de la ligne électrique (40) porté par un bras (26A, 26B, 26C, 268) de l'armature (12) décrit des spires s'enroulant autour dudit bras de l'armature.

9. Composant électrique (10 ; 110 ; 210) selon la revendication 8, dans lequel une distance minimale (E40) séparant deux spires adjacentes d'un segment (46B, 46D, 48B, 48D) de la ligne électrique (40) porté par un bras (26A, 26B, 26C, 268) de l'armature (12), mesurée sur la face plane extérieure (24A, 24B, 24C, 24D) dudit bras de l'armature perpendiculairement à l'axe principal (X), est inférieure à 400 µm, de préférence inférieure à 250 µm.

10. Composant électrique (10 ; 110 ; 210) selon l'une des revendications 8 et 9, dans lequel on définit une première portion de l'armature et une deuxième portion de l'armature, chaque portion de l'armature étant délimitée entre un premier plan radial (P1, P3) passant par l'axe principal (X) et un deuxième plan radial (P2, P4) passant par l'axe principal et décalé du premier plan radial, un angle de décalage (α) entre le premier plan radial et le deuxième plan radial étant identique pour la première portion de l'armature et pour la deuxième portion de l'armature, et dans lequel une surface cumulée des spires comprises dans la première portion de l'armature diffère d'une surface cumulée des spires comprises dans la deuxième portion de l'armature de moins de 5%.

11. Composant électrique (10 ; 110 ; 210) selon l'une des revendications 1 à 10, dans lequel l'ouverture centrale (16) de l'armature (12) est en forme de cylindre droit.

12. Composant électrique (10 ; 110 ; 210) selon l'une des revendications 1 à 11, dans lequel le composant électrique (10 ; 110 ; 210) est un capteur de type Rogowski.

13. Procédé de fabrication d'un composant électrique (10 ; 110 ; 210) selon l'une quelconque des revendications 1 à 12, le procédé de fabrication comprenant :
- une préparation de l'armature (12), comprenant successivement :
∘ une fourniture ou une fabrication de l'armature ;
∘ une gravure par laser de l'armature, pour graver au moins une piste d'amorce décrivant les segments (46B, 46D, 48B, 48D) de la ligne électrique (40) portés par l'armature et décrivant les plots de contact (50A, 50A', 50B, 50B', 50C, 50C', 50D, 50D'), et où l'additif organométallique est localement activé ;
∘ une métallisation de chaque piste d'amorce avec un métal conducteur pour former les segments de la ligne électrique portés par l'armature et pour former les plots de contact directement en surface de l'armature ;
- une fourniture ou une fabrication de la carte de circuit imprimé (14) ;
- un positionnement de l'armature sur la carte de circuit imprimé ; et
- une soudure des plots de contact sur la carte de circuit imprimé.

14. Procédé de fabrication selon la revendication 13, dans lequel la soudure des plots de contact (50A, 50A', 50B, 50B', 50C, 50C', 50D, 50D') sur la carte de circuit (14) imprimé s'effectue en utilisant un four de refusion par convection dans lequel le composant électrique (10) est placé.

## Patentansprüche

1. Elektrische Komponente (10 ; 110 ; 210), umfassend:
- eine Armatur (12), die aus einem Material gebildet ist, das einen polymeren Kunststoff und einen organometallischen Zusatzstoff umfasst, wobei die Armatur eine zentrale Öffnung (16) begrenzt, welche die Armatur entlang einer Hauptachse (X) durchquert,
- eine Leiterplatte (14), an der die Armatur (12) befestigt ist, wobei die Leiterplatte und die Armatur entlang der Hauptachse (X) übereinanderliegen, und
- eine unverzweigte elektrische Leitung (40), die einen ersten Verbindungspunkt (42), einen zweiten Verbindungspunkt (44) und Segmente (46A, 46B, 46C, 46D, 48A, 48B, 48C, 48D) umfasst, die sich vom ersten Verbindungspunkt bis zum zweiten Verbindungspunkt gemäß einer Umlaufrichtung (F40) der elektrischen Leitung aufeinanderfolgen, wobei jedes Segment entweder von der Armatur oder von der Leiterplatte getragen wird, wobei jedes Segment mit dem folgenden Segment durch eine jeweilige, zu der elektrischen Leitung gehörende Verbindungsstelle (50A, 50A', 50B, 50B', 50C, 50C', 50D, 50D') verbunden ist,
**dadurch gekennzeichnet, dass** die Armatur (12) umfasst:
- mindestens vier Arme (26A, 26B, 26C, 26D), wobei die mindestens vier Arme ringförmig um die zentrale Öffnung (16) verteilt sind, wobei jeder Arm der Armatur eine jeweilige Außenfläche (24A, 24B, 24C, 24D) bildet, die zu der Armatur gehört und sich parallel zu der Hauptachse (X) erstreckt, und wobei jeder Arm (26A, 26B, 26C, 26D) eines der Segmente (46B, 46D, 48B, 48D) der elektrischen Leitung trägt, und
- mindestens vier Verbindungsstellen (28A, 28B, 28C, 28D), wobei jeder Arm über eine der Verbindungsstellen mit dem benachbarten Arm verbunden ist,
dadurch, dass die Leiterplatte (14) mindestens vier Zweige (32A, 32B, 32C, 32D) umfasst, wobei die mindestens vier Zweige ringförmig um die Hauptachse verteilt sind und ein zentrales Loch begrenzen, das von der Hauptachse (X) durchquert wird, wobei jeder Zweig (32A, 32B, 32C, 32D) der Leiterplatte (14) eines der Segmente (46A, 46C, 48A, 48C) der elektrischen Leitung (40) trägt,
dadurch, dass:
- der erste Verbindungspunkt (42) der elektrischen Leitung gemäß der Umlaufrichtung (F40) der elektrischen Leitung mit dem ersten Segment (46A) verbunden ist, wobei das erste Segment von einem der Zweige (32A) der Leiterplatte (14) getragen wird, und
- das letzte Segment (48D) der elektrischen Leitung gemäß der Umlaufrichtung mit dem zweiten Verbindungspunkt (44) verbunden ist, wobei das letzte Segment von einem Arm (26A) der Armatur (12) getragen wird,
und dadurch, dass:
- die elektrische Komponente (10) Kontaktpads (50A, 50A', 50B, 50B', 50C, 50C', 50D, 50D') umfasst, die von der Armatur (12) getragen und jeweils an einer der Verbindungsstellen (28A, 28B, 28C, 28D) der Armatur angeordnet sind, und
- jede Verbindungsstelle zwischen zwei aufeinanderfolgenden Segmenten der elektrischen Leitung, wobei eines der beiden aufeinanderfolgenden Segmente von einem Arm der Armatur getragen wird und wobei das andere der beiden aufeinanderfolgenden Segmente von einem Zweig der Leiterplatte getragen wird, durch eines der Kontaktpads gebildet ist.

2. Elektrische Komponente (10; 110; 210) nach Anspruch 1, wobei die Kontaktpads (50A, 50A', 50B, 50B', 50C, 50C', 50D, 50D') paarweise gruppiert sind, wobei eine Verbindungsstelle (28A, 28B, 28C, 28D) der Armatur (12) entweder ein Paar Kontaktpads oder kein Kontaktpad trägt.

3. Elektrische Komponente (10; 110; 210) nach Anspruch 2, wobei die elektrische Komponente vier Paare von Kontaktpads (50A, 50A', 50B, 50B', 50C, 50C', 50D, 50D') umfasst, und wobei die Segmente (46A, 46B, 46C, 46D, 48A, 48B, 48C, 48D) der elektrischen Leitung (40) gemäß der Umlaufrichtung (F40) zwischen einem von einem Zweig (32A, 32B, 32C, 32D) der Leiterplatte (14) getragenen Segment und einem von einem Arm (26A, 26B, 26C, 26D) der Armatur (12) getragenen Segment alternieren.

4. Elektrische Komponente (10; 110; 210) nach Anspruch 2, wobei die elektrische Komponente mindestens zwei Paare von Kontaktpads (50A, 50A', 50C, 50C') umfasst, und wobei die Segmente (146A, 146B, 146C, 146D, 148A, 148B, 148C, 148D) der elektrischen Leitung (140) gemäß der Umlaufrichtung (F140) zwischen zwei aufeinanderfolgenden Segmenten, die jeweils von einem Zweig (32A, 32B, 32C, 32D) der Leiterplatte (14) getragen werden, und zwei aufeinanderfolgenden Segmenten, die jeweils von einem Arm (26A, 26B, 26C, 26D) der Armatur (12) getragen werden, alternieren.

5. Elektrische Komponente (10; 110; 210) nach Anspruch 2, wobei die elektrische Komponente mindestens ein Paar von Kontaktpads (50A, 50A') umfasst, und wobei die Segmente (246A, 246B, 246C, 246D, 248A, 248B, 248C, 248D) der elektrischen Leitung (240) gemäß der Umlaufrichtung (F240) zwischen vier aufeinanderfolgenden Segmenten, die jeweils von einem Zweig (32A, 32B, 32C, 32D) der Leiterplatte (14) getragen werden, und vier aufeinanderfolgenden Segmenten, die jeweils von einem Arm (26A, 26B, 26C, 26D) der Armatur (12) getragen werden, alternieren.

6. Elektrische Komponente (10 ; 110 ; 210) nach einem der Ansprüche 1 bis 5, wobei die elektrische Komponente (10; 110; 210) eine von der Leiterplatte (14) getragene elektrische Hilfsleitung (56) umfasst, und wobei die elektrische Hilfsleitung zwischen dem vierten Segment (146D) und dem fünften Segment (148A) der elektrischen Leitung mit der elektrischen Leitung verbunden ist.

7. Elektrische Komponente (10 ; 110 ; 210) nach einem der Ansprüche 1 bis 6, wobei die Armatur (12) über die Kontaktpads (50A, 50A', 50B, 50B', 50C, 50C', 50D, 50D') an der Leiterplatte (14) befestigt ist.

8. Elektrische Komponente (10 ; 110 ; 210) nach einem der Ansprüche 1 bis 7, wobei jedes von einem Arm (26A, 26B, 26C, 26D) der Armatur (12) getragene Segment (46B, 46D, 48B, 48D) der elektrischen Leitung (40) Windungen beschreibt, die sich um den Arm der Armatur wickeln.

9. Elektrische Komponente (10; 110; 210) nach Anspruch 8, wobei ein minimaler Abstand (E40), der zwei benachbarte Windungen eines von einem Arm (26A, 26B, 26C, 26D) der Armatur (12) getragenen Segments (46B, 46D, 48B, 48D) der elektrischen Leitung (40) voneinander trennt, gemessen auf der ebenen Außenfläche (24A, 24B, 24C, 24D) des Arms der Armatur senkrecht zu der Hauptachse (X), kleiner als 400 µm, vorzugsweise kleiner als 250 µm, ist.

10. Elektrische Komponente (10 ; 110 ; 210) nach einem der Ansprüche 8 und 9, wobei ein erster Abschnitt der Armatur und ein zweiter Abschnitt der Armatur definiert werden, wobei jeder Abschnitt der Armatur zwischen einer ersten radialen Ebene (P1, P3), die durch die Hauptachse (X) verläuft, und einer zweiten radialen Ebene (P2, P4), die durch die Hauptachse verläuft und gegenüber der ersten radialen Ebene versetzt ist, begrenzt ist, wobei ein Versatzwinkel (α) zwischen der ersten radialen Ebene und der zweiten radialen Ebene für den ersten Abschnitt der Armatur und für den zweiten Abschnitt der Armatur identisch ist, und wobei eine kumulierte Fläche der in dem ersten Abschnitt der Armatur enthaltenen Windungen sich von einer kumulierten Fläche der in dem zweiten Abschnitt der Armatur enthaltenen Windungen um weniger als 5% unterscheidet.

11. Elektrische Komponente (10 ; 110 ; 210) nach einem der Ansprüche 1 bis 10, wobei die zentrale Öffnung (16) der Armatur (12) die Form eines geraden Zylinders aufweist.

12. Elektrische Komponente (10 ; 110 ; 210) nach einem der Ansprüche 1 bis 11, wobei die elektrische Komponente (10 ; 110 ; 210) ein Sensor vom Rogowski-Typ ist.

13. Verfahren zur Herstellung einer elektrischen Komponente (10 ; 110 ; 210) nach einem der Ansprüche 1 bis 12, wobei das Herstellungsverfahren umfasst:
- eine Vorbereitung der Armatur (12), umfassend nacheinander:
∘ eine Bereitstellung oder eine Herstellung der Armatur;
o ein Laserätzen der Armatur, um mindestens eine Anfangsleiterbahn zu ätzen, die die von der Armatur getragenen Segmente (46B, 46D, 48B, 48D) der elektrischen Leitung (40) beschreibt und die Kontaktpads (50A, 50A', 50B, 50B', 50C, 50C', 50D, 50D') beschreibt, und wobei der organometallische Zusatzstoff lokal aktiviert wird;
o eine Metallisierung jeder Anfangsleiterbahn mit einem leitfähigen Metall, um die von der Armatur getragenen Segmente der elektrischen Leitung zu bilden und um die Kontaktpads direkt an der Oberfläche der Armatur zu bilden;
- eine Bereitstellung oder eine Herstellung der Leiterplatte (14);
- eine Positionierung der Armatur auf der Leiterplatte; und
- ein Löten der Kontaktpads auf der Leiterplatte.

14. Herstellungsverfahren nach Anspruch 13, wobei das Löten der Kontaktpads (50A, 50A', 50B, 50B', 50C, 50C', 50D, 50D') auf der Leiterplatte (14) unter Verwendung eines Konvektions-Reflow-Ofens erfolgt, in den das elektrische Bauelement (10) eingesetzt wird.

## Claims

1. Electrical component (10; 110; 210), comprising:
- a frame (12), which is formed by a material comprising a polymer plastic material and an organometallic additive, the frame delimiting a central opening (16), which passes through the frame along a main axis (X),
- a printed circuit board (14), on which the frame (12) is fixed, the printed circuit board and the frame being superimposed along the main axis (X), and
- an unbranched electrical line (40), which comprises a first connection point (42), a second connection point (44) and segments (46A, 46B, 46C, 46D, 48A, 48B, 48C, 48D) which follow one another from the first connection point to the second connection point, according to a direction of circulation (F40) of the electrical line, each segment being supported either by the frame or by the printed circuit board, each segment being connected to the following segment by a respective junction (50A, 50A', 50B, 50B', 50C, 50C', 50D, 50D') belonging to the electrical line, **characterized in that** the frame (12) comprises:
- at least four arms (26A, 26B, 26C, 26D), the at least four arms being distributed in a loop around the central opening (16), each arm of the frame forming a respective outer face (24A, 24B, 24C, 24D) belonging to the frame and extending parallel to the main axis (X) and each arm (26A, 26B, 26C, 26D) supporting only one of the segments (46B, 46D, 48B, 48D) of the electrical line, and
- at least four joints (28A, 28B, 28C, 28D), each arm being connected to the adjacent arm by means of one of the joints,
**in that** the printed circuit board (14) comprises at least four branches (32A, 32B, 32C, 32D), the at least four branches being distributed in a loop around the main axis and delimiting a central hole, passed through by the main axis (X), each branch (32A, 32B, 32C, 32D) of the printed circuit board (14) supporting only one of the segments (46A, 46C, 48A, 48C) of the electrical line (40),
**in that**:
- the first connection point (42) of the electrical line is connected to the first segment (46A) of the electrical line, according to the direction of circulation (F40), the first segment being supported by one of the branches (32A) of the printed circuit board (14), and
- the last segment (48D) of the electrical line, according to the direction of circulation, is connected to the second connection point (44), the last segment being supported by an arm (26A) of the frame (12),
and **in that**:
- the electrical component (10) comprises contact pads (50A, 50A', 50B, 50B', 50C, 50C', 50D, 50D') supported by the frame (12) and each arranged at one of the joints (28A, 28B, 28C, 28D) of the frame, and
- each junction between two consecutive segments of the electrical line, one of the two consecutive segments being supported by an arm of the frame and the other of the two consecutive segments being supported by a branch of the printed circuit board, is formed by one of the contact pads.

2. Electrical component (10; 110; 210) according to claim 1, wherein the contact pads (50A, 50A', 50B, 50B', 50C, 50C', 50D, 50D') are grouped in pairs, a joint (28A, 28B, 28C, 28D) of the frame (12) supporting either a pair of contact pads or no contact pad.

3. Electrical component (10; 110; 210) according to claim 2, wherein the electrical component comprises four pairs of contact pads (50A, 50A', 50B, 50B', 50C, 50C', 50D, 50D'), and wherein the segments (46A, 46B, 46C, 46D, 48A, 48B, 48C, 48D) of the electrical line (40), according to the direction of circulation (F40), alternate between a segment supported by a branch (32A, 32B, 32C, 32D) of the printed circuit board (14) and a segment supported by an arm (26A, 26B, 26C, 26D) of the frame (12).

4. Electrical component (10; 110; 210) according to claim 2, wherein the electrical component comprises at least two pairs of contact pads (50A, 50A', 50C, 50C'), and wherein the segments (146A, 146B, 146C, 146D, 148A, 148B, 148C, 148D) of the electrical line (140), according to the direction of circulation (F140), alternate between two consecutive segments each supported by a branch (32A, 32B, 32C, 32D) of the printed circuit board (14) and two consecutive segments each supported by an arm (26A, 26B, 26C, 26D) of the frame (12).

5. Electrical component (10; 110; 210) according to claim 2, wherein the electrical component comprises at least one pair of contact pads (50A, 50A'), and wherein the segments (246A, 246B, 246C, 246D, 248A, 248B, 248C, 248D) of the electrical line (240), according to the direction of circulation (F240), alternate between four consecutive segments each supported by a branch (32A, 32B, 32C, 32D) of the printed circuit board (14) and four consecutive segments each supported by an arm (26A, 26B, 26C, 26D) of the frame (12).

6. Electrical component (10; 110; 210) according to any one of claims 1 to 5, wherein the electrical component (10; 110; 210) comprises an auxiliary electrical line (56), supported by the printed circuit board (14), and wherein the auxiliary electrical line is connected to the electrical line (40) between the fourth segment (146D) and the fifth segment (148A) of the electrical line.

7. Electrical component (10; 110; 210) according to any one of claims 1 to 6, wherein the frame (12) is fixed to the printed circuit board (14) by means of the contact pads (50A, 50A', 50B, 50B', 50C, 50C', 50D, 50D').

8. Electrical component (10; 110; 210) according to any one of claims 1 to 7, wherein each segment (46B, 46D, 48B, 48D) of the electrical line (40) supported by an arm (26A, 26B, 26C, 26D) of the frame (12) describes coils winding around said arm of the frame.

9. Electrical component (10; 110; 210) according to claim 8, wherein a minimum distance (E40) separating two adjacent coils of a segment (46B, 46D, 48B, 48D) of the electrical line (40) supported by an arm (26A, 26B, 26C, 26D) of the frame (12), measured on the planar outer face (24A, 24B, 24C, 24D) of said arm of the frame perpendicularly to the main axis (X), is less than 400 µm, preferably less than 250 µm.

10. Electrical component (10; 110; 210) according to any one of claims 8 and 9, wherein a first portion of the frame and a second portion of the frame are defined, each portion of the frame being delimited between a first radial plane (P1, P3) passing through the main axis (X) and a second radial plane (P2, P4) passing through the main axis and offset from the first radial plane, an offset angle (α) between the first radial plane and the second radial plane being identical for the first portion of the frame and for the second portion of the frame, and wherein a cumulative surface area of the coils comprised in the first portion of the frame differs from a cumulative surface area of the coils comprised in the second portion of the frame by less than 5%.

11. Electrical component (10; 110; 210) according to any one of claims 1 to 10, wherein the central opening (16) of the frame (12) is in the shape of a right cylinder.

12. Electrical component (10; 110; 210) according to any one of claims 1 to 11, wherein the electrical component (10; 110; 210) is a Rogowski-type sensor.

13. Method for manufacturing an electrical component (10; 110; 210) according to any one of claims 1 to 12, the manufacturing method comprising:
- preparing the frame (12), successively comprising:
∘ providing or manufacturing the frame;
∘ laser etching the frame, to etch at least one initiation track describing the segments (46B, 46D, 48B, 48D) of the electrical line (40) supported by the frame and describing the contact pads (50A, 50A', 50B, 50B', 50C, 50C', 50D, 50D'), and where the organometallic additive is locally activated;
∘ metallizing each initiation track with a conductive metal to form the segments of the electrical line supported by the frame and to form the contact pads directly on the surface of the frame;
- providing or manufacturing the printed circuit board (14);
- a positioning of the frame on the printed circuit board; and
- soldering of the contact pads on the printed circuit board.

14. Manufacturing method according to claim 13, wherein the soldering of the contact pads (50A, 50A', 50B, 50B', 50C, 50C', 50D, 50D') on the printed circuit board (14) is carried out using a convection reflow oven in which the electrical component (10) is placed.
